# EUROPÄISCHE PATENTSCHRIFT

(11) **EP 1 752 556 B1**
(45) Veröffentlichungstag und Bekanntmachung des Hinweises auf die Patenterteilung: **31.10.2007**
(21) Anmeldenummer: 05016738.6
(22) Anmeldetag: 02.08.2005
(51) Int. Cl.: C23C 14/34, H01J 37/34

(54) **Rohrkathode für die Verwendung bei einem Sputterprozess**
Tubular cathode for use in sputtering.
Cathode tubulaire pour pulvérisation cathodique

(43) Veröffentlichungstag der Anmeldung: 14.02.2007
(73) Patentinhaber: Applied Materials GmbH & Co. KG, 63755 Alzenau (DE)
(72) Erfinder: Schuhmacher,Manfred, D-63755 Alzenau (DE); Joos,Gerhard, D-63785 Obemburg (DE)
(74) Vertreter: Schickedanz, Willi

(56) Entgegenhaltungen:
- US-A1- 2003 136 662
- US-B1- 6 409 897

## Beschreibung

Die Erfindung betrifft eine Rohrkathode nach dem Oberbegriff des Patentanspruchs 1.
Bei der Beschichtung von Substraten werden neben so genannten Planarkathoden immer häufiger Rohrkathoden eingesetzt, weil diese einen sehr hohen Wirkungsgrad besitzen. Derartige Rohrkathoden weisen einen Targetträger, ein Target und ein Magnetsystem auf, das sich ortsfest in dem Targetträger befindet.
Ist das Target durch den Sputterprozess verbraucht, werden Target und Targetträger zusammen entsorgt, und es wird ein neues Target mit neuem Targetträger in eine entsprechende Sputteranlage eingebaut.
Es ist bereits ein Verfahren für die Herstellung von zylindrischen Sputtertargets bekannt, bei dem ein Kühlrohr gebildet wird, das Durchgänge aufweist, durch welche ein Kühlmittel fließt (US 2001/0047936 A1). Außerdem werden mehrere Ringe hergestellt, die aus einem Material bestehen, das gesputtert werden soll. Anschließend werden die hergestellten Ringe über das Kühlrohr gestülpt, sodass die vorstehenden Teile dieser Ringe, wenn sie gesputtert werden, eine Schicht auf einem Substrat bilden.
Weiterhin ist ein Sputtertarget bekannt, das eine Röhre aufweist sowie eine Hülse, die aus Sputter-Material besteht, wobei der innere Durchmesser der Hülse größer als der äußere Durchmesser der Röhre ist, sodass sich ein ringförmiger Raum zwischen Röhre und Hülse bildet (US 6 409 897 B1). Der ringförmige Raum wird wenigstens teilweise von einem thermisch leitenden Material eingenommen, wobei dieses thermisch leitende Material ein aus Einzelteilchen bestehendes Material enthält, welches bei Umgebungstemperatur fließt.
Außerdem ist ein zylindrisches Target bekannt, das zylindrisches Targetmaterial aufweist, welches sich auf einem Träger befindet (US 2003/0136662 A1). Zwischen dem Targetmaterial und dem Träger befindet sich ein Pufferelement. Dieses Pufferelement kann ein Kohlenstoff-Filz sein.
Auf ähnliche Weise ist zwischen einem Targetträger und einem Target eine elektrisch leitende Matte eingefügt (US 6 787 011 B2).
Des Weiteren ist eine Targetanordnung mit einem zylindrischen Trägerelement und mindestens einem ein Targetmaterial aufweisenden hohlzylindrischen Target bekannt, welches das Trägerelement zumindest abschnittsweise umgibt (DE 10 2004 031 161 A1). Zwischen dem Trägerelement und dem Target sind ein Klemmring oder ein oder mehrere Klemmkeile vorgesehen.
Schließlich ist auch noch eine Targetträgeranordnung bekannt, die einen Träger aufweist, auf dem ein Targetmantel angeordnet ist (DE 102 31 203 A1). Hierbei ist der Targetmantel durch eine Targethülse gebildet, die auf den Träger aufgeschoben ist, wobei zwischen dem Träger und der Targethülse wenigstens ein Klemmelement wirksam angeordnet ist.
Der Erfindung liegt die Aufgabe zugrunde, das Aufschieben eines ein- oder mehrteiligen Targetrohrs auf ein Trägerrohr zu erleichtern.
Diese Aufgabe wird gemäß den Merkmalen des Patentanspruchs 1 gelöst.
Die Erfindung betrifft somit eine Rohrkathode mit einem Targetträger und einem Target. Das Target kann hierbei ein- oder mehrteilig sein. Zwischen Targetträger und Target sind mehrere ringförmige Elemente aus einem wärmeleitfähigen Material entlang der Längsachse des Targetträgers gelegt. Mit Hilfe von schmalen Ringen sind die ringförmigen Elemente voneinander getrennt. Das Target weist an wenigstens einer Stirnseite eine Abfasung auf, die es ermöglicht, das Target leicht über die einzelnen ringförmigen Elemente zu schieben.
Der mit der Erfindung erzielte Vorteil besteht insbesondere darin, dass auch schwierig handhabbare Targets z. B. aus Molybdän oder ITO mit einer geringen Wärmeausdehnung leichter als bisher einsetzbar sind, weil das Bonden entfällt. Außerdem können die abgesputterten Targetstücke wieder verwendet werden, da sie nicht durch ein Bond-Mittel verunreinigt sind. Bei Verwendung mehrteiliger Targets sind die Materialspannungen, die aufgrund der Erhitzung des Targetmaterials durch den Sputterprozess auftreten, dadurch kompensierbar, dass man zwischen benachbarten Targetringen eine minimale Dehnungsspalte vorsieht.
Ausführungsbeispiele der Erfindung sind in den Zeichnungen dargestellt und werden im Folgenden näher beschrieben. Es zeigen:
- Fig. 1: eine Rohrkathode mit einteiligem Target;
- Fig. 2: eine Rohrkathode mit mehrteiligem Target;
- Fig. 3: ein Trägerrohr mit einem Targetteil;
- Fig. 4: ein Trägerrohr mit zwei Targetteilen;
- Fig. 5: ein Trägerrohr mit zwei aufgeschobenen Ring-Targets.

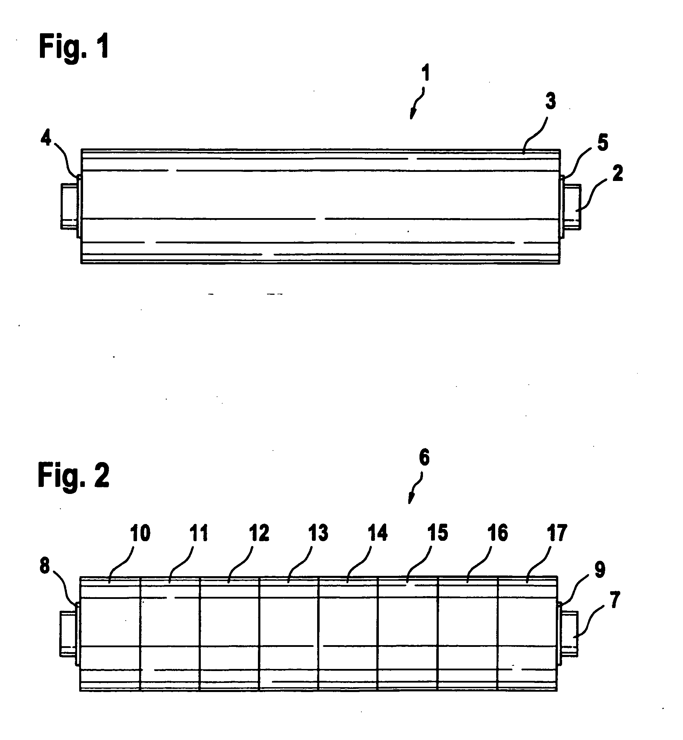

In der Fig. 1 ist eine Rohrkathode 1 in einer Seitenansicht dargestellt. Man erkennt hierbei ein Trägerrohr 2 und ein einteiliges Target 3 sowie zwei Sicherungsringe 4, 5.
Eine andere Rohrkathode 6 zeigt die Fig. 2. Man erkennt hierbei wieder ein Trägerrohr 7 sowie zwei Sicherungsringe 8, 9. Das Target setzt sich in diesem Fall jedoch aus mehreren Ring-Targets 10 bis 17 zusammen.

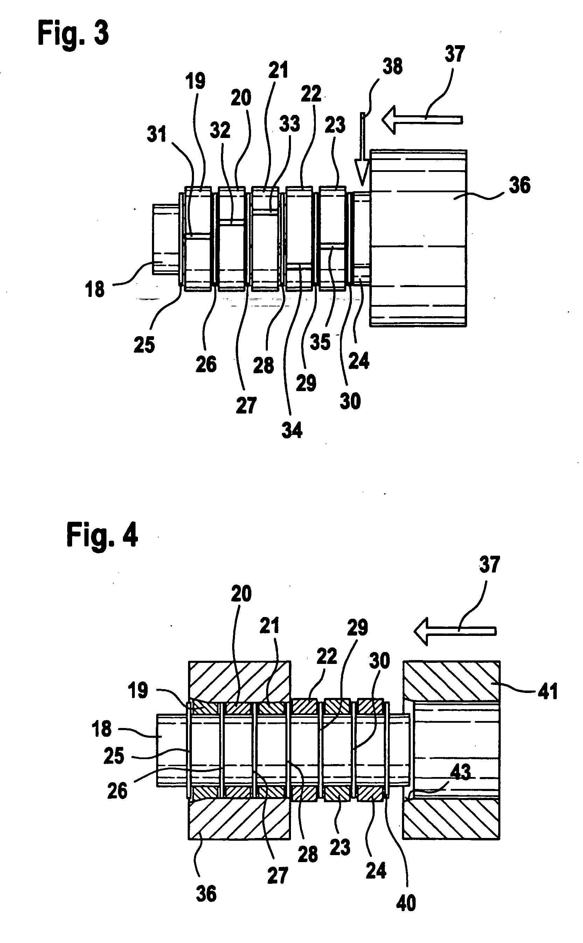

In der Fig. 3 sind bis auf eines alle Ring-Targets abgenommen, sodass man die Oberfläche eines Trägerrohrs 18 erkennt. Dieses Trägerrohr 18 weist mehrere Segmente auf, in denen sich jeweils ein Grafit-Folien-Streifen 19 bis 24 befindet. Diese Grafit-Folien-Streifen bestehen aus Naturgrafit, der zu einer Grafit-Einlagerungsverbindung umgewandelt ist. Entsprechende Folien werden beispielsweise unter dem Namen SIGRAFLEX von der Firma SGL Technik GmbH aus 86405 Meitingen vertrieben.
Die Segmente des Trägerrohrs 18 werden durch Ringe 25 bis 30 gebildet, die äquidistant um den zylindrischen Umfang des Trägerrohrs 18 verlaufen, wobei zwischen benachbarten Ringen die Grafit-Folien-Streifen 19 bis 24 verlaufen. Innerhalb eines Grafit-FolienStreifens 19 bis 24 sind Trennfugen 31 bis 35 in Richtung des Umfangs des Trägerrohrs 18 vorgesehen und relativ zueinander versetzt, sodass eine lineare Anordnung mehrerer Trennfugen ausgeschlossen ist.
Ein Ring-Target 36 wird in Richtung eines Pfeils 37 auf den Grafit-Folien-Streifen 24 aufgeschoben. Hierdurch wird ein Druck in Richtung eines Pfeils 38 ausgeübt, sodass der elastische Grafit-Folien-Streifen 24 zusammengedrückt wird. Sein äußerer Durchmesser ist deshalb kleiner als die äußeren Durchmesser der anderen Grafit-Folien-Streifen 19 bis 23, die noch nicht zusammengedrückt sind. Außerdem ist seine Trennfuge verschwunden. Beim Weiterschieben des Ring-Targets 36 werden auch die Grafit-Folien-Streifen 19 bis 23 zusammengedrückt.
Es ist nicht erforderlich, das Trägerrohr 18 vollständig mit Grafit-Folienstreifen 19 bis 24 zu bestücken und dann Ring-Targets über die vollständige, jeweils frei bleibende Targetlänge aufzuschieben. Vielmehr ist es sogar materialschonender, nur so viele Grafit-Folien-Streifen 19 bis 24 in die Segmente einzulegen, dass das momentan aufzuschiebende Ring-Target vollständig mit der Folie unterfüttert wird. Erst vor dem Aufschieben des nächsten Targetrings werden die notwendigen weiteren Segmente mit Grafit-Folien-Streifen ausgelegt. Somit werden die Targetringe nur über die jeweils benötigten Grafit-Folien-Streifen geschoben. Nur bei einem Targetrohr muss dieses über alle vollständig mit Grafit-Folie ausgelegten Segmente geschoben werden.
In der Fig. 4 ist noch einmal die Anordnung der Fig. 3 gezeigt, jedoch mit zwei geschnittenen Ring-Targets 36,41 und mit geschnittenen Grafit-Folien-Streifen 19 bis 24. Die Trennfugen 31 bis 35 sind hierbei nicht zu erkennen. Außer dem Ring-Target 36, das im aufgeschobenen Zustand dargestellt ist, erkennt man auch noch ein weiteres Ring-Target 41, das gerade aufgeschoben wird. Beide Ring-Targets 36, 41 weisen an ihrem jeweils linken Ende Abfasungen 42, 43 auf, die ein Aufschieben auf die Grafit-Folien-Streifen 19 bis 24 erleichtern. Der Außendurchmesser der aufgelegten und mit einem Schnellkleber gesicherten Grafit-Folien-Streifen 19 bis 24 ist im nicht zusammengedrückten Zustand größer als der Innendurchmesser des Ring-Targets 41.

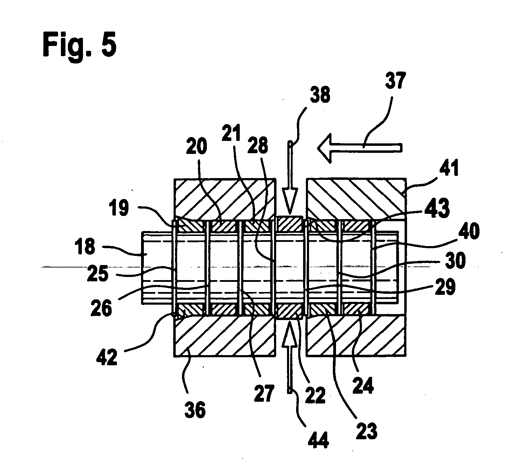

Die Fig. 5 zeigt noch einmal die Anordnung gemäß Fig. 4, wobei jedoch das Ring-Target 41 weiter nach links verschoben ist. Man erkennt hierbei, dass durch Abfasung 43 des Ring-Targets 41, das nach links in Richtung des Pfeils 37 verschoben wird, der Grafit-Folien-Streifen 22 an seiner Oberkante erfasst wird. Beim Weiterschieben des Ring-Targets 41 in Richtung des Pfeils 37 werden Kräfte in Richtung der Pfeile 38, 44 auf den Grafit-Folien-Streifen 22 ausgeübt, sodass er zusammengedrückt wird und schließlich mit seiner Oberkante auf gleichem Niveau liegt wie die Oberkante der Ringe 25 bis 30, 40.
Ein Vorwärmen des Ring-Targets 41 erleichtert das Aufschieben oder Pressen des Ring-Targets 41. Die Trennstellen der Targetringe 36, 41 können über den Ringen 25 bis 30 zu liegen kommen. Auf diese Weise können Targets bis zu 4 m Länge problemlos verwendet werden.
Durch die Unterteilung des Trägerrohrs 18 in Segmente mittels der Ringe 25 bis 30 wird die auf die Grafit-Folien-Streifen 19 bis 23 wirkende Reibungskraft beim Aufschieben des Targetrohrs verringert, da sich die Grafit-Folien-Streifen 19 bis 23 an den Ringen 25 bis 30 abstützen können und ein Verrutschen der Grafit-Folien-Streifen 19 bis 23 verhindert wird. Dadurch können die Grafit-Folien-Streifen 19 bis 23 mit höherer Pressung zwischen Ring-Target 36 und Trägerrohr 18 eingeklemmt werden, was zu einer besseren elektrischen und thermischen Leitfähigkeit führt.
Um zu verhindern, dass in den Dehnungsspalten von ca. 0,5 mm zwischen benachbarten Ring-Targets 36, 41 Grafit oder das Material der Ringe 25 bis 30 durch Sputtern abgetragen wird, was zur Verunreinigung der abzuscheidenden Schichten führen würde, können die Ring-Targets am Innendurchmesser mit radialen Einstichen bzw. Stegen versehen werden, die wie Nut und Feder ineinander greifen. So könnte beispielsweise das Ring-Target 36 in Fig. 4 oberhalb des Folienstreifens 21 eine Aussparung haben, während das Ring-Target 41 einen entsprechenden Vorsprung aufweisen könnte, der beim Zusammenschieben der Ring-Targets 36, 41 in die Aussparung eingeführt wird.
Auf diese Weise können die Ringe 25 bis 30 und 40 nicht dem Bombardement von Plasma-Teilchen ausgesetzt werden, weil diese Teilchen nur auf die Ring-Targets treffen können.
Die verwendeten Grafit-Folien haben senkrecht zur Schichtung einen größeren Wärmeausdehnungskoeffizienten als parallel dazu. Eine Wärmeausdehnung parallel zur Schichtung wird durch die Trennfugen 31 bis 35 kompensiert. Die höhere Wärmeausdehnung senkrecht zur Schichtung hat zur Folge, dass bei weniger guter Kühlung die Folie verstärkt zwischen dem Ring-Target 36 und dem Trägerrohr 18 eingeklemmt wird, was den Wärmetransport wiederum erhöht, sodass die Kühlung zunimmt.

## Patentansprüche

1. Rohrkathode für die Verwendung bei einem Sputterprozess, mit einem Targetträger und einem Target, wobei sich zwischen Targetträger und Target eine elektrisch und thermisch gut leitende Schicht befindet, **dadurch gekennzeichnet, dass** die thermisch gut leitende Schicht entlang der Längsachse des Targetträgers (18) in mehrere Einzelschichten (19 - 24) unterteilt ist, die einen Abstand voneinander haben.

2. Rohrkathode nach Anspruch 1, **dadurch gekennzeichnet, dass** die Schicht (19 - 24) überwiegend aus Grafit besteht.

3. Rohrkathode nach Anspruch 1, **dadurch gekennzeichnet, dass** Targetträger (2, 7, 18) und Target (3, 10 - 17, 36, 41) rohr- oder zylinderförmig ausgebildet sind.

4. Rohrkathode nach Anspruch 1, **dadurch gekennzeichnet, dass** mehrere Ring-Targets (10 - 17, 36, 41) auf einem Targetträger (7, 18) angeordnet sind.

5. Rohrkathode nach Anspruch 4, **dadurch gekennzeichnet, dass** ein Ring-Target (36,41) wenigstens-an einem-Ende-eine-Schlupffase (42,43) aufweist.

6. Rohrkathode nach Anspruch 1 oder Anspruch 2, **dadurch gekennzeichnet, dass** die Einzelschichten (19 - 24) durch jeweils eine Folie gebildet sind.

7. Rohrkathode nach Anspruch 1, **dadurch gekennzeichnet, dass** die Einzelschichten (19 - 24) durch Grafit-Ringe gebildet sind.

8. Rohrkathode nach Anspruch 7, **dadurch gekennzeichnet, dass** jeder Grafit-Ring mit einer quer verlaufenden Trennfuge (31 - 35) versehen ist

9. Rohrkathode nach Anspruch 7 und Anspruch 8, **dadurch gekennzeichnet, dass** die Trennfugen (31 - 35) der Grafit-Ringe (19 - 24) auf dem Umfang des Targetträgers (18) räumlich zueinander versetzt angeordnet sind.

10. Rohrkathode nach Anspruch 1, **dadurch gekennzeichnet, dass** sich zwischen den Einzelschichten Ringe (25 - 30) befinden, die um den Umfang des Targetträgers (2, 7, 18) verlaufen.

11. Rohrkathode nach Anspruch 4, **dadurch gekennzeichnet, dass** benachbarte Ring-Targets so ausgebildet sind, dass sie an ihren Stirnseiten wie Nut und Feder ineinander greifen.

12. Rohrkathode nach Anspruch 1, **dadurch gekennzeichnet, dass** das Target (3, 10-17) aus Molybdän besteht.

13. Rohrkathode nach Anspruch 1, **dadurch gekennzeichnet, dass** das Target (3, 10 - 17) aus ITO besteht.

## Claims

1. Tube cathode for use in a sputter process with a target carrier and a target, wherein between target carrier and target a layer with good electric and thermal conductivity is located, **characterized in that** the thermally well conducting layer is divided along the longitudinal axis of the target carrier (18) into several discrete layers (19-24) which are spaced apart from one another.

2. Tube cathode as claimed in claim 1, **characterized in that** the layer (19-24) is predominantly comprised of graphite.

3. Tube cathode as claimed in claim 1, **characterized in that** the target carrier (2, 7, 18) and the target (3, 10-17, 36, 41) are formed tubularly or cylindrically.

4. Tube cathode as claimed in claim 1, **characterized in that** several ring targets (10-17, 36, 41) are disposed on one target carrier (7, 18).

5. Tube cathode as claimed in claim 4, **characterized in that** a ring target (36, 41) has at least at one end a slip chamfer (42, 43).

6. Tube cathode as claimed in claim 1 or claim 2, **characterized in that** each of the discrete layers (19-24) is formed-by a foil.

7. Tube cathode as claimed in claim 1, **characterized in that** the discrete layers (19-24) are formed by graphite rings.

8. Tube cathode as claimed in claim 7, **characterized in that** each graphite ring is provided with a joint line (31-35) extending transversely.

9. Tube cathode as claimed in claim 7 and claim 8, **characterized in that** the joint lines (31-35) of the graphite rings (19-24) are disposed on the circumference of the target carrier (18) such that they are spatially offset with respect to one another.

10. Tube cathode as claimed in claim 1, **characterized in that** between the discrete layers are located rings (25-30) which extend about the circumference of the target carrier (2, 7, 18).

11. Tube cathode as claimed in claim 4, **characterized in that** adjacent ring targets are formed such that they mesh at their end faces like tongue and groove.

12. Tube cathode as claimed in claim 1, **characterized in that** the target (3, 10-17) is comprised of molybdenum.

13. Tube cathode as claimed in claim 1, **characterized in that** the target (3, 10-17) is comprised of ITO.

## Revendications

1. Cathode tubulaire pour l'utilisation lors d'un processus de pulvérisation cathodique avec un support de cible et une cible, une couche bonne conductrice électrique et thermique se trouvant entre le support de cible et la cible, **caractérisée en ce que** la couche bonne conductrice thermique est divisée le long de l'axe longitudinal du support de cible (18) en plusieurs couches individuelles (19 à 24) présentant un écart l'une par rapport à l'autre.

2. Cathode tubulaire selon la revendication 1, **caractérisée en ce que** la couche (19 à 24) est essentiellement en graphite.

3. Cathode tubulaire selon la revendication 1, **caractérisée en ce que** le support de cible (2, 7, 18) et la cible (3, 10 à 17, 36, 41) sont conçus sous forme tubulaire ou cylindrique.

4. Cathode tubulaire selon la revendication 1, **caractérisée en ce que** plusieurs cibles annulaires (10 à 17, 36, 41) sont disposées sur un support de cible (7, 18).

5. Cathode tubulaire selon la revendication 4, **caractérisée en ce que**, une cible annulaire comporte au moins sur une extrémité une phase de dérive (42, 43).

6. Cathode tubulaire selon la revendication 1 ou 2, **caractérisée en ce que** les couches individuelles (19 à 24) sont formées chacune par un film.

7. Cathode tubulaire selon la revendication 1, **caractérisée en ce que** les couches individuelles (19 à 24) sont formées par des anneaux de graphite.

8. Cathode tubulaire selon la revendication 7, **caractérisée en ce que** chaque anneau de graphite est muni d'un joint de séparation (31 à 35) s'étendant à la transversale.

9. Cathode tubulaire selon la revendication 7 et la revendication 8, **caractérisée en ce que** les joints de séparation (31 à 35) des anneaux de graphite (19 à 24) sont disposés sur la périphérie du support de cible (18) en étant physiquement décalés l'un par rapport à l'autre.

10. Cathode tubulaire selon la revendication 1, **caractérisée en ce que**, entre les couches individuelles se trouvent des anneaux (25 à 30) qui s'étendent autour de la périphérie du support de cible (2, 7, 18) .

11. Cathode tubulaire selon la revendication 4, **caractérisée en ce que** des cibles annulaires voisines sont conçues de sorte à s'engager sur leurs faces frontales comme des rainures et languettes.

12. Cathode tubulaire selon la revendication 1, **caractérisée en ce que** la cible (3, 10 à 17) est en molybdène.

13. Cathode tubulaire selon la revendication 1, **caractérisée en ce que** la cible (3, 10 à 17) est en ITO.
